(19) **Europäisches Patentamt / European Patent Office / Office européen des brevets**

(11) **EP 4 757 565 A1**

(12) **EUROPEAN PATENT APPLICATION**
published in accordance with Art. 153(4) EPC

(43) Date of publication:
**10.06.2026 Bulletin 2026/24**

(21) Application number: **24849075.7**

(22) Date of filing: **26.07.2024**

(51) International Patent Classification (IPC):
**H10N 50/10** (2023.01)  **H10B 61/00** (2023.01)
**H10N 50/20** (2023.01)  **H10N 52/00** (2023.01)

(52) Cooperative Patent Classification (CPC):
**H10B 61/00; H10N 50/10; H10N 50/20; H10N 52/00**

(86) International application number:
**PCT/JP2024/026734**

(87) International publication number:
**WO 2025/028421 (06.02.2025 Gazette 2025/06)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.07.2023 US 202363529410 P**

(71) Applicants:
• **JSR Corporation**
**Tokyo 105-8640 (JP)**
• **The University of Tokyo**
**Bunkyo-ku, Tokyo 113-8654 (JP)**
• **Tohoku University**
**Sendai-shi, Miyagi 980-8577 (JP)**

(72) Inventors:
• **TOGA, Yuuta**
**Tokyo 105-8640 (JP)**
• **KORETSUNE, Takashi**
**Sendai-shi, Miyagi 980-8577 (JP)**
• **TANAKA, Katsuhiro**
**Tokyo 113-8654 (JP)**
• **NAKATSUJI, Satoru**
**Tokyo 113-8654 (JP)**

(74) Representative: **Becker, Eberhard**
**Becker Kurig & Partner**
**Patentanwälte mbB**
**Bavariastraße 7**
**80336 München (DE)**

(54) **ANTIFERROMAGNETIC BODY MATERIAL, TWO-LAYER FILM OF MAGNETIC BODY AND INSULATOR, TUNNEL MAGNETORESISTIVE ELEMENT, AND MAGNETIC MEMORY**

(57) This antiferromagnetic body material has a hexagonal crystal structure, and comprises: an antiferromagnetic layer formed of $Mn_3A_{1-x}B_x$ (0<x<0.5, A=Ga, Ge, Sn, and B=Mg, Al, Si, P, Mn, Ni, Cu, Zn, As, Ru, Ag, Cd, In, Sb, Os, Au, Hg, Tl, Pb) or $(Mn_{1-p}Cr_p)_3Ga_qGe_rSn_{1-q-r}$ (0<p<0.5, 0<q<1, 0<r<1, and 0<q+r≤1); and an insulator layer laminated on the surface of the same. Preferably, A represents at least one of Ga and Sn. In addition, preferably, B represents at least one of Mg, Al, Si, Mn, Cu, Zn, Ag, Cd, In, Sb, Au, and Tl.

FIG. 4

EP 4 757 565 A1

**Description**

TECHNICAL FIELD

The present disclosure relates to an antiferromagnetic material, a two layer film of a magnetic body and an insulator, a tunnel magnetoresistive element, and a magnetic memory.
This application claims priority based on U.S. Provisional Patent Application No. 63/529,410 filed in the United States on July 28, 2023, the contents of which are incorporated herein by reference.

BACKGROUND ART

A magnetoresistive element is known in which an insulator layer is sandwiched between a ferromagnetic body layer whose magnetization direction can be changed and a ferromagnetic body layer whose magnetization direction is fixed. To increase the speed of such a magnetoresistive element, it has been studied to utilize a layer of an antiferromagnetic body such as $Mn_3Sn$ instead of the ferromagnetic body (see, for example, H. Tsai, et al., "Electrical manipulation of a topological antiferromagnetic state," Nature, volume 580, pages 608-613 (2020)).
WO 2022/220251 A discloses that by sandwiching Ta between $Mn_3Sn$ and a contact layer of an insulator, the roughness of an interface is suppressed and the interface is smoothed, and a readout signal of a magnetic memory element is enhanced.
In addition, X. Chen, et al., "Octupole-driven magnetoresistance in an antiferromagnetic tunnel junction," Nature 613, 490 (2023) discloses that there is a possibility of obtaining a tunnel magnetoresistive element by exchanging the ferromagnetic body layer for an antiferromagnetic body layer such as $Mn_3Sn$ and sandwiching an insulating layer such as MgO between two antiferromagnetic body layers.

PRIOR ART DOCUMENTS

PATENT DOCUMENT

Patent Document 1: WO 2022/220251 A

NON-PATENT DOCUMENTS

Non-Patent Document 1: H. Tsai, et al., "Electrical manipulation of a topological antiferromagnetic state," Nature, volume 580, pages 608-613 (2020)
Non-Patent Document 2: X. Chen, et al., "Octupole-driven magnetoresistance in an antiferromagnetic tunnel junction," Nature 613, 490 (2023)

SUMMARY OF THE INVENTION

PROBLEMS TO BE SOLVED BY THE INVENTION

It is required to obtain such a tunnel magnetoresistive element that has high heat resistance. An object of the present invention is to obtain a tunnel magnetoresistive element and a magnetic memory both having high heat resistance.

MEANS FOR SOLVING THE PROBLEMS

According to one aspect of the present disclosure, an antiferromagnetic material is composed of $Mn_3A_{1-x}B_x$ ($0 < x < 0.5$, A = Ga, Ge, Sn, B = Mg, Al, Si, P, Mn, Ni, Cu, Zn, As, Ru, Ag, Cd, In, Sb, Os, Au, Hg, Tl, Pb) or $(Mn_{1-p}Cr_p)_3Ga_qGe_rSn_{1-q-r}$ ($0 < p < 0.5$, $0 < q < 1$, $0 < r < 1$, $0 < q + r \leq 1$) and has a hexagonal crystal structure.
According to another aspect of the present disclosure, a two layer film of a magnetic body and an insulator includes a layer composed of the ferromagnetic material described above and a layer composed of an insulator laminated on the layer composed of the ferromagnetic material.
According to still another aspect of the present disclosure, a tunnel magnetoresistive element has a second antiferromagnetic film layer laminated on the insulator of the two layer film.
According to still another aspect of the present disclosure, a magnetic memory includes a plurality of the above-described tunnel magnetoresistive elements.

EFFECT OF THE INVENTION

According to the present invention, it is possible to obtain a tunnel magnetoresistive element and a magnetic memory both having high heat resistance.

BRIEF DESCRIPTION OF THE DRAWINGS

A more complete appreciation of the present disclosure and many of the attendant advantages thereof will be readily obtained as the same becomes better understood by reference to the following detailed description when considered in connection with the accompanying drawings.

Fig. 1 is a cross-sectional view illustrating one embodiment of a two layer film of a magnetic body and an insulator.
Fig. 2 is a cross-sectional view illustrating one embodiment of a tunnel magnetoresistive element.
Fig. 3 is a graph in which data are plotted with the element replacement amount of 10% as the upper limit, where an average of absolute values of the magnetic moment at each site is taken as the abscissa and a difference ($\Delta T_N$) in Neel temperature (calculated value) compared with $Mn_3Sn$ is taken as the ordinate.
Fig. 4 is a cross-sectional view explaining the operation of a tunnel magnetoresistive element.
Fig. 5 is a circuit diagram of one embodiment of a magnetic memory.

MODE FOR CARRYING OUT THE INVENTION

In the present description, when an amount, concentration, or other value or parameter is given as a range and/or the description includes a list of upper and lower limit values, this is to be understood as specifically disclosing all integers and fractions within the given range, and all ranges formed from any pair of any upper and lower limit values, regardless of whether or not narrower ranges are individually disclosed. Where a numerical range is recited herein, unless otherwise stated, the range is intended to include not only all integers and fractions within the range, but also endpoints thereof. As one example, a range of 1 to 10 completely describes and includes an independent subrange of 3.4 to 7.2, similar to a list of values of 1, 4, 6, and 10.

In an embodiment of the present disclosure, in a tunnel magnetoresistive element in which an insulator layer is sandwiched between a plurality of antiferromagnetic body layers, when the antiferromagnetic body layers are designed to be layers having a hexagonal crystal structure composed of $Mn_3A_{1-x}B_x$ ($0 < x < 0.5$, A = Ga, Ge, Sn, B = Mg, Al, Si, P, Mn, Ni, Cu, Zn, As, Ru, Ag, Cd, In, Sb, Os, Au, Hg, Tl, Pb) or $(Mn_{1-p}Cr_p)_3Ga_qGe_rSn_{1-q-r}$ ($0 < p < 0.5, 0 < q < 1, 0 < r < 1, 0 < q + r \leq 1$), the resulting tunnel magnetoresistive element can have relatively high heat resistance. Therefore, when the tunnel magnetoresistive element is used in a magnetic memory, the resulting magnetic memory has relatively high heat resistance.

Hereinafter, embodiments of an antiferromagnetic material and each element will be described.

[Antiferromagnetic material, two layer film of magnetic body and insulator, and tunnel magnetoresistive element]

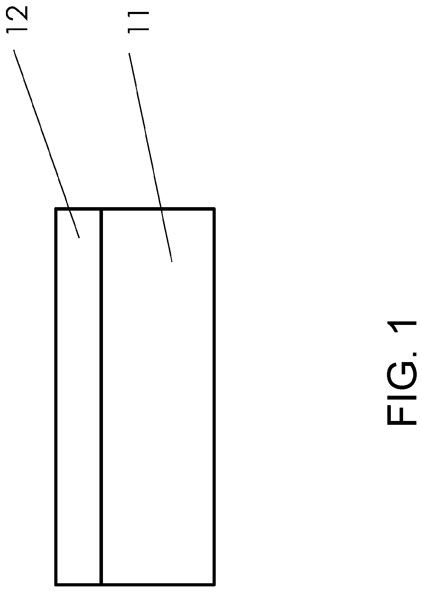

Fig. 1 is a cross-sectional view illustrating one embodiment of a two layer film of a magnetic body and an insulator. An insulator layer 12 is laminated on an antiferromagnetic body layer 11.

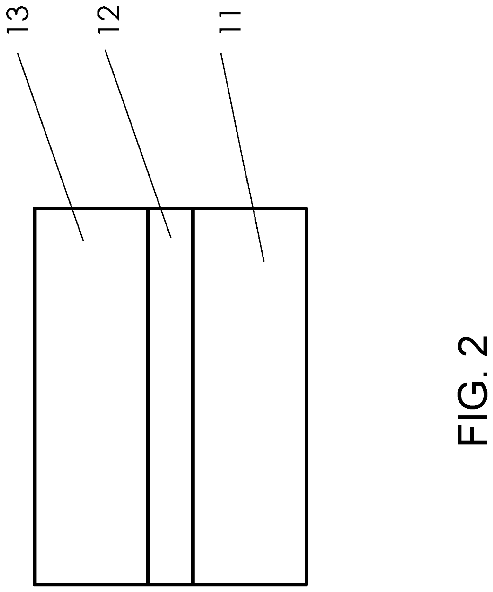

Fig. 2 is a cross-sectional view illustrating one embodiment of a tunnel magnetoresistive element. An insulator layer 12 is laminated on an antiferromagnetic body layer 11, and a second antiferromagnetic body layer 13 is further laminated on the insulator layer 12.

In the two layer film of a magnetic body and an insulator and the tunnel magnetoresistive element of the present disclosure, the materials of the antiferromagnetic body layer 11 and the second antiferromagnetic body layer 13 are each $Mn_3A_{1-x}B_x$ ($0 < x < 0.5$, A = Ga, Ge, Sn, B = Mg, Al, Si, P, Mn, Ni, Cu, Zn, As, Ru, Ag, Cd, In, Sb, Os, Au, Hg, Tl, Pb) or $(Mn_{1-p}Cr_p)_3Ga_qGe_rSn_{1-q-r}$ ($0 < p < 0.5, 0 < q < 1, 0 < r < 1, 0 < q + r \leq 1$) that has a hexagonal crystal structure. A is more preferably at least one of Ga and Sn, and B is more preferably at least one among Mg, Al, Si, Mn, Cu, Zn, Ag, Cd, In, Sb, Au, and Tl. x preferably satisfies $0 < x < 0.5$, and more preferably satisfies $0.15 < x < 0.25$. In addition, p preferably satisfies $0 < p < 0.5$, and more preferably satisfies $0.15 < p < 0.25$. q preferably satisfies $0.2 < q < 0.8$, and more preferably satisfies $0.4 < q < 0.6$. r preferably satisfies $r < 0.5$.

The materials of the antiferromagnetic body layer 11 and the second antiferromagnetic body layer 13 may be the same as or different from each other. In these crystals, spins are under cluster magnetic octupolar polarization, and when a magnetic field is applied or an electric current is applied, the net spin polarization defined by a magnetic octupole can be rotated.

In addition, the thicknesses of the antiferromagnetic body layer 11 and the second antiferromagnetic body layer 13 are each independently, for example, 0.5 nm - 40 nm, preferably 0.5 nm - 30 nm, and more preferably 0.5 nm - 20 nm.

The thickness of the insulator layer 12 is, for example, 0.5 nm - 5 nm, preferably 0.5 nm - 4 nm, and more preferably 1 nm - 3 nm. When each of the layers has such a thickness, the resistance value can be adjusted to a value appropriate for device application.

The inventors of the present disclosure have found by performing a simulation as described below that thermal stability is improved by using a specific material for the antiferromagnetic layers.

(Simulation Method)

To search for an antiferromagnetic materials that affords improved thermal stability of magnetism (i.e., increased Neel temperature), simulation was conducted in the following three steps.

(1) Using antiferromagnetic body $Mn_3X$ (X = Ga, Ge, Sn) having a hexagonal crystal structure as a reference material, to search for materials having a Neel temperature increased from that of the reference material, for two types of materials: (i) materials in which X is partially replaced by another element, and (ii) materials $(Mn, Y)_3(Ga-Ge-Sn)$ in which Mn is partially replaced by another element, and Ga, Ge, and Sn are combined in an arbitrary ratio instead of X.
(2) Among the materials searched above, to search for materials whose magnetic state at Neel temperature or lower is equivalent to that of the reference material.
(3) Among the materials searched above, to search for materials whose structure can exist stably.

Hereinafter, description will be made in order.

(1) Using $Mn_3X$ (X = Ga, Ge, Sn) having a hexagonal crystal structure as a reference material, to search for materials having a Neel temperature increased from that of the reference material, for two types of materials: (i) materials in which X is partially replaced by an arbitrary element, and (ii) materials $(Mn, Y)_3(Ga-Ge-Sn)$ in which Mn is partially replaced by an arbitrary element Y, and Ga, Ge, and Sn are combined at an arbitrary ratio instead of X, search for materials having a Neel temperature increased from that of the reference material.

Elements to be employed for the replacement are 70 elements among atomic numbers 11 (Na) to 83 (Bi) in the periodic table excluding rare gas elements, and the replacement amount is limited up to 50% at the maximum. In addition, regarding the crystal structure (lattice constant and internal coordinates), experimental values of $Mn_3Ga$, $Mn_3Ge$, and $Mn_3Sn$ are used and a lattice constant change due to replacement of elements is not considered. As for $(Mn, Y)_3(Ga-Ge-Sn)$ in (ii), the crystal structure is determined by a linear approximation from the experimental values according to the compounding ratio of Ga, Ge, and Sn. Material systems in which the Neel temperatures determined on the basis of the first principle calculation for the crystal structures determined as described above are higher than the value of $Mn_3(Ga-Ge-Sn)$ as a reference are selected as search candidates. The specific calculation method is as follows.

The first principle calculation of a random replacement system was conducted using the coherent potential approximation (CPA). For each doping system, the classical spin Hamiltonian was constructed as follows:

[Math 1]

$$\mathscr{H} = -2 \sum_{i<j} J_{ij}\left(n_i, n_j\right) \boldsymbol{s}_i \cdot \boldsymbol{s}_j, \quad \#$$

Here, $J_{ij}(n_i, n_j)$ is the exchange coupling constant between the i-th and j-th sites up to the cutoff length 2a (a is the lattice constant), and $s_{i(, j)}$ is a normalized classical spin moment at the i(, j)-th site. The type dependence of the coupling constant between the atoms n_i and n_j was calculated on the basis of the first principle calculation (implemented in the AkaiKKR code (http://kkr.issp.u-tokyo.ac.jp/jp/)) using the Korringa-Kohn-Rostoker (KKR) Green's function method of the paramagnetic local moment disorder state and the Liechtenstein formula (A.I. Liechtenstein, et al. Magn. Mater. 67, 65 (1987)). In this calculation, the atomic sphere approximation and the generalized gradient approximation parametrization of Perdew, Becke, and Erzenhof (PBE) were used. For the 4f state of rare earth elements, so-called open core approximation was employed.

A native Monte Carlo (MC) simulation was conducted on the above Hamiltonian to determine the Neel temperature from the peak of the magnetic heat capacity. In each MC simulation, 100,000 MC steps for relaxation and 100,000 MC steps for calculation of magnetization were performed on 5 to 10 atomic arrangements constructed with different random number sequences.

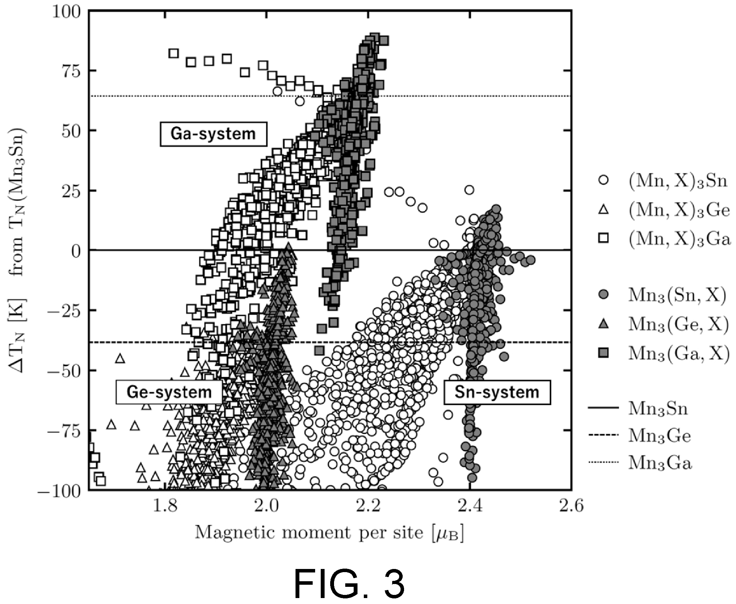

As one example, the results illustrated in Fig. 3 are obtained. In Fig. 3, data are plotted with 10% as the upper limit of the replacement amount of an element, using the average of the absolute values of the magnetic moments at each site as the abscissa and the difference ($\Delta T_N$) in the Néel temperature (calculated value) compared with $Mn_3Sn$ as the ordinate. Horizontal lines in the figure correspond to $Mn_3Sn$, $Mn_3Ge$, and $Mn_3Ga$, and the portions above the horizontal lines correspond to search materials. For example, in the region of Sn-System, which is obtained by replacing elements with $Mn_3Sn$ as a base, materials satisfying $\Delta T_N > 0$ correspond to search materials.

(2) Among the materials searched above, to search for materials whose magnetic state at Neel temperature or lower is equivalent to that of the reference material.

For the material system obtained in the above (1), a magnetic structure at a temperature equal to or lower than the Neel temperature is obtained by Monte Carlo calculation, and materials having the same cluster magnetic octupole polarization as the original $Mn_3X$ (X = Ga, Ge, Sn) are selected.

(3) Among the materials searched above, to search for materials whose structure can exist stably

For the material system obtained in the above (2), the energy stability of an alloy is examined on the basis of the convex hull of the formation energy by the KKR-CPA method incorporating the Full Potential method. When compared with Ge replacement or Ga replacement of Sn in $Mn_3Sn$, which is already known to be experimentally stable, those which are energetically stable to the same extent are selected.

By the simulation calculation described above, it has been found that in a tunnel magnetoresistive element, when the materials of the antiferromagnetic body layer 11 and the second antiferromagnetic body layer 13 are $Mn_3A_{1-x}B_x$ ($0 < x <$ 0.5, A = Ga, Ge, Sn, B = Mg, Al, Si, P, Mn, Ni, Cu, Zn, As, Ru, Ag, Cd, In, Sb, Os, Au, Hg, Tl, Pb) or $(Mn_{1-p}Cr_p)_3Ga_qGe_rSn_{1-q-r}$ ($0 < p < 0.5, 0 < q < 1, 0 < r < 1, 0 < q + r \leq 1$), the thermal stability of the magnetism (the Neel temperature) is increased, and the materials can exist stably in terms of energy.

In one embodiment of the present disclosure, the Neel temperature (calculated value) of the antiferromagnetic body layers is higher by 10 K or more than the Neel temperature (calculated value) of $Mn_3Sn$. The Neel temperature (calculated value) of $Mn_3Sn$ is about 420 K.

In one embodiment of the present disclosure, the antiferromagnetic body layers (namely, $Mn_3A_{1-x}B_x$ ($0 < x < 0.5$, A = Ga, Ge, Sn, B = Mg, Al, Si, P, Mn, Ni, Cu, Zn, As, Ru, Ag, Cd, In, Sb, Os, Au, Hg, Tl, Pb) or $(Mn_{1-p}Cr_p)_3Ga_qGe_rSn_{1-q-r}$ ($0 < p < 0.5, 0 < q < 1, 0 < r < 1, 0 < q + r \leq 1$)) have, at a temperature equal to or lower than the Neel temperature, the same cluster magnetic octupolar polarization as $Mn_3X$ (X = Ga, Ge, Sn) serving as a reference in finding materials by the simulation calculation.

In one embodiment of the present disclosure, the energy difference between the tetragonal structure and the hexagonal structure for the same composition of the antiferromagnetic body layers has a value smaller than the value of $Mn_3Sn$ or $Mn_3Ga$.

In one embodiment of the present disclosure, the insulator layer and the two antiferromagnetic body layers are in direct contact. In another embodiment, one or more other layers are interposed between the insulator layer and the antiferromagnetic body layer. The other layer disposed between the antiferromagnetic body layer and the insulator layer may be any layer that can be formed by a publicly known film-forming methods such as sputtering or epitaxial growth (MBE, MOCVD, etc.) and is not particularly limited. Examples of one or more other layers in this case include a layers containing Ta or Ru as a material.

[Method for producing two layer film of magnetic body and insulator and tunnel magnetoresistive element]

The two layer film of a magnetic body and an insulator and the tunnel magnetoresistive element can be formed by the procedure including (1) formation of an antiferromagnetic body layer 11, (2) lamination of an insulator layer 12 on the antiferromagnetic body layer 11, and (3) lamination of a second antiferromagnetic body layer 13 on the insulator layer 12. Hereinafter, the method will be specifically described.

(1) Formation of antiferromagnetic body layer 11

The antiferromagnetic body layer 11 can be formed by forming a film of the material of the present disclosure on a substrate to be an electrode by a publicly known film forming means such as sputtering or epitaxial growth (MBE, MOCVD, etc.). When sputtering is used, for example, the same material as $Mn_3A_{1-x}B_x$ ($0 < x < 0.5$, A = Ga, Ge, Sn, B = Mg, Al, Si, P, Mn, Ni, Cu, Zn, As, Ru, Ag, Cd, In, Sb, Os, Au, Hg, Tl, Pb) or $(Mn_{1-p}Cr_p)_3Ga_qGe_rSn_{1-q-r}$ ($0 < p < 0.5, 0 < q < 1, 0 < r < 1, 0 < q + r \leq 1$), which is to be formed into a film, is used as a target material.

Examples of the material of the substrate to be an electrode (the substrate electrode layer) include W, Pt, and Ta, and the thickness thereof is typically 1 nm - 20 nm, and preferably 1 nm - 5 nm.

(2) Lamination of insulator layer 12 on antiferromagnetic body layer 11

Next, the insulator layer 12 is formed on the antiferromagnetic body layer 11 by a publicly known film forming means such as sputtering. When sputtering is used, an oxide, nitride, oxynitride, or the like of metal can be used as a target material. Sputtering that is reactive under an oxygen or nitrogen atmosphere may also be used.

(3) Lamination of second antiferromagnetic body layer 13 on insulator layer 12

Next, the antiferromagnetic body layer 13 can be formed by forming a film of the material of the present disclosure on the insulator layer 12 by a publicly known film forming means such as epitaxial growth (MBE, MOCVD, etc.).
When sputtering is used, examples of a target material include those of the antiferromagnetic body layer 11.

[Operation of tunnel magnetoresistive element]

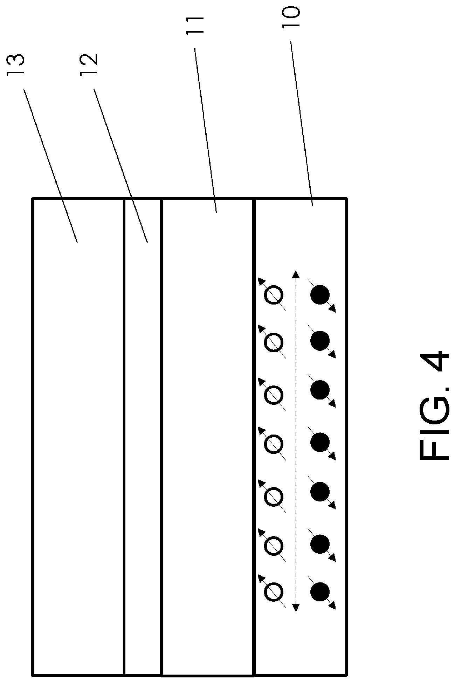

Fig. 4 is a cross-sectional view illustrating one embodiment of a tunnel magnetoresistive element. On the substrate electrode layer 10, an insulator layer 12 and a second antiferromagnetic body layer 13 are laminated in this order on the surface of the antiferromagnetic body layer 11. Here, examples of the material of the substrate electrode layer 10 include W, Pt, and Ta as spin current generating materials.
The net spin polarization direction of the first antiferromagnetic layer is preferably perpendicular to the antiferromagnetic body layer 11, but may be inclined. In this tunnel magnetoresistive element, the electric resistance changes depending on the relative angle between the spin polarization direction of the antiferromagnetic body layer 11 and the spin polarization direction of the second antiferromagnetic body layer 13. Therefore, by rotating the spin polarization direction of the antiferromagnetic body layer 11, it is possible to switch between the low resistance state and the high resistance state. It is possible to make such a tunnel magnetoresistive element function as a storage cell by using a difference in resistance value before and after the switching as storage information.
For example, when a current flows in a layer parallel direction (for example, in a horizontal broken line arrow direction in Fig. 4) in the substrate electrode layer 10, a spin current is generated in a direction orthogonal to the current by spin-orbit interaction (this phenomenon is a spin Hall effect), and a magnetic torque is generated in the antiferromagnetic body layer 11. By changing the current direction in the substrate electrode layer 10, spin polarization direction rotation is caused in the antiferromagnetic body layer 11.
As described above, the antiferromagnetic body layer 11 and the second antiferromagnetic body layer 13 may be formed of the same material or may be formed of different materials. From the viewpoint of increasing the difference between the low resistance state and the high resistance state, the spin polarization direction of the antiferromagnetic body layer 11 and the spin polarization direction of the second antiferromagnetic body layer 13 are preferably directed in planes parallel to each other. That is, if the spin polarization direction of the antiferromagnetic body layer 11 is substantially perpendicular to the layer direction, it is preferable that the spin polarization direction of the second antiferromagnetic body layer 13 is also substantially perpendicular to the layer direction, and if the spin polarization direction of the first antiferromagnetic body layer 11 is substantially parallel to the layer direction, it is preferable that the spin polarization direction of the second antiferromagnetic body layer 13 is also substantially parallel to the layer direction.
In the tunnel magnetoresistive element of the present disclosure, a TMR ratio can be obtained up to relatively high temperature by using a specific material for the insulator layer according to the plane orientation of the surface of the antiferromagnetic body layer.

[Magnetic memory]

A magnetic memory can be configured by using a plurality of the tunnel magnetoresistive elements described above as storage cells. A publicly known configuration can be used for the magnetic memory. For example, the structures of the magnetic memories described in US 2022/0149269 A and US 2019/0267540 A can be used. The descriptions of US 2022/0149269 A and US 2019/0267540 A regarding the structures of the magnetic memories are incorporated herein.

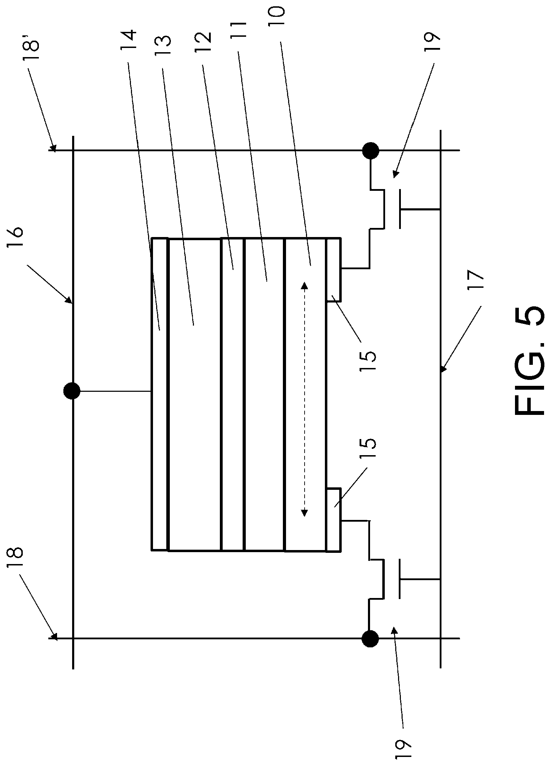

Fig. 5 is a circuit diagram illustrating one embodiment of wiring of a storage cell constituting a part of the magnetic memory of the present disclosure. The storage cells as illustrated in Fig. 5 are arranged in a matrix and driven.
In each storage cell, the insulator layer 12 and the second antiferromagnetic body layer 13 are laminated in this order on the surface of the antiferromagnetic body layer 11 laminated on the substrate electrode layer 10 to form a tunnel magnetoresistive element. The operation of this tunnel magnetoresistive element is similar to that described above for the tunnel magnetoresistive element.
The substrate electrode layer 10 is provided with two power supply electrodes 15 and 15, and the power supply electrodes 15 and 15 are connected to the sources of transistors 19 and 19, respectively. The gates of the transistors 19 and 19 are connected to a word line 17, and the drains of the two transistors 19 and 19 are connected to a first write bit line 18 and a second write bit line 18', respectively. The second antiferromagnetic body layer 13 is connected to a read bit line 16 via the electrode 14.

Here, in the case of switching data by changing the resistance value, to make one data state, the first write bit line 18 is set to H level, and the second write bit line 18' is set to L level. Then, when the word line 17 is set to H level, a current flows in the substrate electrode layer 10 from the first write bit line 18 toward the second write bit line 18', so that the spin polarization of the antiferromagnetic body layer 11 falls into a state corresponding to the current, and this is one data state.

When the data is switched, the first write bit line 18 is set to L level, and the second write bit line 18' is set to H level. Then, when the word line 17 is set to H level, the current flows in the substrate electrode layer 10 from the second write bit line 18' toward the first write bit line 18, so that the spin polarization of the antiferromagnetic body layer 11 changes, and the data is switched.

When the data stored in the storage cell is read, one of the first write bit line 18 and the second write bit line 18' is set to H level and the other is opened. Then, when the read bit line 16 is set to L level and the word line 17 is set to H level, a current flows from the first write bit line 18 and the second write bit line 18' toward the read bit line 16. Therefore, by measuring the magnitude of the current, it is determined whether the storage cell is in the high resistance state or the low resistance state, and data written in the storage cell is acquired.

In one embodiment of the magnetic memory, by arranging the storage cells as shown in Fig. 4 on a matrix, and controlling the levels of the write bit lines, the read bit lines, and the word line by a controller, a prescribed write/read operation is conducted.

In the magnetic memory of the present embodiment, a read signal can be obtained at a relatively high temperature by using a specific material for the antiferromagnetic body layer according to the plane orientation of the surface of the antiferromagnetic body layer.

Obviously, numerous modifications and variations of the present invention are possible in light of the above teachings. It is therefore to be understood that within the scope of the appended claims, the invention may be practiced otherwise than as specifically described herein.

INDUSTRIAL APPLICABILITY

The antiferromagnetic material and the two layer film of a magnetic body and an insulator of the present invention can be utilized as a tunnel magnetoresistive element and a magnetic memory.

DESCRIPTION OF REFERENCE SIGNS

| | |
|---|---|
| 10 | Substrate electrode layer |
| 11 | Antiferromagnetic body layer |
| 12 | Insulator layer |
| 13 | Second antiferromagnetic body layer |
| 14 | Electrode |
| 15 | Power supply electrode |
| 19 | Transistor |
| 17 | Word line |
| 18 | First write bit line |
| 18' | Second write bit line |
| 16 | Read bit line |

**Claims**

1. An antiferromagnetic material having a hexagonal crystal structure and composed of $Mn_3A_{1-x}B_x$ ($0 < x < 0.5$, A = Ga, Ge, Sn, B = Mg, Al, Si, P, Mn, Ni, Cu, Zn, As, Ru, Ag, Cd, In, Sb, Os, Au, Hg, Tl, Pb) or $(Mn_{1-p}Cr_p)_3Ga_qGe_rSn_{1-q-r}$ ($0 < p < 0.5$, $0 < q < 1$, $0 < r < 1$, $0 < q + r \le 1$).

2. The antiferromagnetic material according to claim 1, wherein A is at least one of Ga and Sn.

3. The antiferromagnetic material according to claim 1 or 2, wherein B is at least one of Mg, Al, Si, Mn, Cu, Zn, Ag, Cd, In, Sb, Au, and Tl.

4. The antiferromagnetic material according to any one of claims 1 to 3, wherein $0 < x < 0.5$, $0 < p < 0.5$, $0.2 < q < 0.8$, and r < 0.5.

5. A two layer film of a magnetic body and an insulator, comprising: a layer composed of the ferromagnetic material according to any one of claims 1 to 4; and a layer composed of an insulator laminated on the layer composed of the ferromagnetic material.

6. A tunnel magnetoresistive element comprising: the two layer film of a magnetic body and an insulator according to claim 5; and a second antiferromagnetic film layer laminated on the insulator of the two layer film.

7. A magnetic memory comprising a plurality of the tunnel magnetoresistive elements according to claim 6.

8. An antiferromagnetic material having a hexagonal crystal structure and composed of $Mn_3A_{1-x}B_x$ ($0 < x < 0.5$, A = Ga, Ge, Sn, B = Mg, Al, Si, P, Mn, Ni, Cu, Zn, Ru, Ag, Cd, In, Os, Au, Hg, Tl) or $(Mn_{1-p}Cr_p)_3Ga_qGe_rSn_{1-q-r}$ ($0 < p < 0.5$, $0 < q < 1$, $0 < r < 1$, $0 < q + r \leq 1$).

9. The antiferromagnetic material according to claim 8, wherein A is at least one of Ga and Sn.

10. The antiferromagnetic material according to claim 8 or 9, wherein B is at least one of Mg, Al, Si, Mn, Cu, Zn, Ag, Cd, In, Au, and Tl.

11. The antiferromagnetic material according to any one of claims 8 to 10, wherein $0 < x < 0.5$, $0 < p < 0.5$, $0.2 < q < 0.8$, and $r < 0.5$.

12. A two layer film of a magnetic body and an insulator, comprising: a layer composed of the ferromagnetic material according to any one of claims 8 to 11; and a layer composed of an insulator laminated on the layer composed of the ferromagnetic material.

13. A tunnel magnetoresistive element comprising: the two layer film of a magnetic body and an insulator according to claim 12; and a second antiferromagnetic film layer laminated on the insulator of the two layer film.

14. A magnetic memory comprising a plurality of the tunnel magnetoresistive elements according to claim 13.

FIG. 1

13

12

11

FIG. 2

FIG. 3

EP 4 757 565 A1

EP 4 757 565 A1

FIG. 4

FIG. 5

EP 4 757 565 A1

## INTERNATIONAL SEARCH REPORT

| | International application No. |
|---|---|
| | **PCT/JP2024/026734** |

| | |
|---|---|
| **A.** | **CLASSIFICATION OF SUBJECT MATTER** |

*H10N 50/10*(2023.01)i; *H10B 61/00*(2023.01)i; *H10N 50/20*(2023.01)i; *H10N 52/00*(2023.01)i
FI:  H10N50/10 Z; H10N52/00 Z; H10N50/20; H10B61/00

According to International Patent Classification (IPC) or to both national classification and IPC

| | |
|---|---|
| **B.** | **FIELDS SEARCHED** |

Minimum documentation searched (classification system followed by classification symbols)

H10N50/10; H10B61/00; H10N50/20; H10N52/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| X | WO 2017/018391 A1 (THE UNIVERSITY OF TOKYO) 02 February 2017 (2017-02-02) paragraphs [0013], [0042], [0049], [0081]-[0082], fig. 12 | 1-3, 5-10, 12-14 |
| A | | 4,11 |
| A | JP 2021-145116 A (THE UNIVERSITY OF TOKYO, DOWA HOLDINGS CO., LTD.) 24 September 2021 (2021-09-24) entire text, all drawings | 1-14 |
| A | JP 10-284321 A (KABUSHIKI KAISHA TOSHIBA) 23 October 1998 (1998-10-23) entire text, all drawings | 1-14 |
| A | US 2020/0212291 A1 (INTEL CORPORATION) 02 July 2020 (2020-07-02) entire text, all drawings | 1-14 |

| ☐ Further documents are listed in the continuation of Box C. | ☑ See patent family annex. |
|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **30 September 2024** | **08 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
Information on patent family members

International application No.

**PCT/JP2024/026734**

| Patent document cited in search report | | | Publication date (day/month/year) | Patent family member(s) | | | Publication date (day/month/year) |
|---|---|---|---|---|---|---|---|
| WO | 2017/018391 | A1 | 02 February 2017 | US 2018/0301177 A1 paragraphs [0024], [0053], [0060], [0092]-[0093], fig. 12 | | | |
| JP | 2021-145116 | A | 24 September 2021 | (Family: none) | | | |
| JP | 10-284321 | A | 23 October 1998 | US 5976713 A entire text, all drawings CN 1206175 A CN 1523575 A | | | |
| US | 2020/0212291 | A1 | 02 July 2020 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63529410
- WO 2022220251 A

- US 20220149269 A
- US 20190267540 A

**Non-patent literature cited in the description**

- **H. TSAI et al.** Electrical manipulation of a topological antiferromagnetic state. *Nature*, 2020, vol. 580, 608-613

- **X. CHEN et al.** Octupole-driven magnetoresistance in an antiferromagnetic tunnel junction. *Nature*, 2023, vol. 613, 490
- **A.I. LIECHTENSTEIN et al.** *Magn. Mater.*, 1987, vol. 67, 65